# EUROPÄISCHE PATENTSCHRIFT

(11) **EP 1 213 836 B1**
(45) Veröffentlichungstag und Bekanntmachung des Hinweises auf die Patenterteilung: **08.09.2004**
(21) Anmeldenummer: 01126887.7
(22) Anmeldetag: 12.11.2001
(51) Int. Cl.: H03J 5/24, H03B 5/12

(54) **Oszillatorschaltung mit umschaltbarer Schwingfrequenz**
Oscillator circuit having switchable resonant frequency
Circuit d'oscillateur commutable de fréquence de résonance

(30) Priorität: 08.12.2000 DE 10061241
(43) Veröffentlichungstag der Anmeldung: 12.06.2002
(73) Patentinhaber: Infineon Technologies AG, 81669 München (DE)
(72) Erfinder: Traub, Johann, 89415 Lauingen (DE)
(74) Vertreter: Epping Hermann & Fischer

(56) Entgegenhaltungen:
- US-A- 4 827 226
- US-A- 6 091 304
- US-A- 6 127 900
- US-B1- 6 239 665

## Beschreibung

Die vorliegende Erfindung betrifft eine Oszillatorschaltung.

Spannungsgesteuerte Oszillatoren (Voltage Controlled Oscillator, VCO) kommen beispielsweise in Sende- und Empfangssystemen insbesondere in der Hochfrequenztechnik zur Anwendung. Beispielsweise zum Aufbauen von Phasenregelschleifen (PLL, Phase Locked Loop) können spannungsgesteuerte Oszillatoren verwendet werden. Dort kann zum einen die Anforderung bestehen, die Schwingfrequenz des Oszillators analog, das heißt stufenlos zu verstellen. Weiterhin kann es aber auch gewünscht sein, die Schwingfrequenz des Oszillators in diskreten Stufen umzuschalten.

In integrierten, spannungsgesteuerten Oszillatoren kommen als Resonator üblicherweise LC-Schwingkreise zur Anwendung. Diese beruhen auf dem Prinzip, daß ein LC-Resonator mittels eines Verstärkers entdämpft wird, vergleiche Tietze, Schenk: Halbleiter-Schaltungstechnik, 10. Auflage 1993, S.458 ff. Die Schwingfrequenz des LC-Oszillators ergibt sich dabei aus der wirksamen Induktivität und der wirksamen Kapazität der Oszillatorschaltung.

Die stufenlose Einstellung der Frequenz eines LC-Oszillators erfolgt üblicherweise mit in Sperrichtung betriebenen Kapazitätsdioden, deren Kapazitätswert von der angelegten Sperrspannung abhängt. Das Verändern der Schwingfrequenz in festen, diskreten Stufen hingegen kann durch Wirksam- oder Wegschalten von Kapazitäten mit festem Kapazitätswert erfolgen.

Schaltet man Kapazitäten zu einem LC-Schwingkreis hinzu, so wird die Schwingkreisfrequenz zu tieferen Frequenzen hin verstimmt. Sind die Schalter jedoch offen, wirken nur noch die parasitären Kapazitäten des schaltbaren Kondensators und des Schalters selbst als frequenzverstimmende Elemente.

In dem Dokument DE 43 32 798 A1 ist eine Schaltungsanordnung für einen abstimmbaren Schwingkreis angegeben, bei dem im Resonator je ein Schalter seriell mit je einer Kapazität verschaltet ist, wobei die Kapazitätswerte binär abgestuft sind. So kann die Resonanzfrequenz des Oszillators zwischen mehreren Stufen umgeschaltet werden.

In dem Dokument Darabi, Abidi: A 4.5-mW 900-MHz CMOS Receiver For Wireless Paging", IEEE Journal of Solid-State Circuits, Vol. 35, No. 8, 2000, Seiten 1085 bis 1095 ist ein einstellbares Filter angegeben, dessen Filtereigenschaften dadurch umschaltbar sind, daß binär abgestufte Kapazitäten, welche parallel geschaltet sind, mit je einem in Serie zu je einer Kapazität angeordneten CMOS-Schalttransistor zu- oder abschaltbar sind.

In dem Dokument Mourant et al.: "A Low Phase Noise Monolithic VCO in SiGe BiCMOS", IEEE 2000, Nr. 0-7803-5687-X/00 ist in Figur 2 ein VCO-Schaltplan angegeben, welcher sowohl abstimmbare Kapazitätsdioden D3, D4, als auch Bandumschalter aufweist, welche jeweils zwei Transistoren in MOS-Technik umfassen.

Das Dokument KRAL, A. et al.: "RF-CMOS Oscillators with Switched Tuning", IEEE 1998, Custom Integrated Circuits Conference, 1998, Seiten 555-558 zeigt einen spannungsgesteuerten LC-Oszillator, bei dem zur Bereichsumschaltung Kapazitäten vorgesehen sind, denen je ein Hochfrequenzschalter zugeordnet und seriell angeschlossen ist.

Den angegebenen Oszillatorschaltungen ist der Nachteil gemeinsam, daß sie entweder eine verhältnismäßig große parasitäre Kapazität des Schalters im ausgeschalteten und/oder einen verhältnismäßig großen Serienwiderstand des Schalters im eingeschalteten Zustand haben. Dies ist dadurch bedingt, daß bei Verwendung von MOS-Transistoren als elektronische Schalter zum Erzielen eines kleinen On-Serienwiderstandes ein großer Transistor, zum Erzielen geringer, parasitärer Kapazitäten, im ausgeschalteten Zustand jedoch ein kleiner Transistor erforderlich ist.

Aufgabe der vorliegenden Erfindung ist es, eine Oszillatorschaltung anzugeben, bei der die Schwingfrequenz des Oszillators umschaltbar ausgeführt ist. Dabei sollen parasitäre Kapazität und Durchschaltwiderstand der Umschalter gering sein, um ein großes Kapazitätsverhältnis zwischen verschiedenen Schaltzuständen sowie gute Phasenrausch-Eigenschaften zu erzielen.

Erfindungsgemäß wird die Aufgabe mit einer Oszillatorschaltung gelöst, aufweisend
- einen symmetrisch aufgebauten Oszillatorkern mit zumindest einer Induktivität und zumindest einer Kapazität, die einen Resonanzkreis mit einem symmetrischen Schwingknoten bilden,
- zwei schaltbare Kapazitäten, die mit je einem Anschluß mit dem Schwingknoten verbunden sind und an ihren freien Anschlüssen einen Schaltknoten bilden und
- eine Schalteinheit zum Verändern einer Resonanzkreis-Frequenz durch Wirksamschalten der schaltbaren Kapazitäten, umfassend einen ersten Schalter zum direkten niederohmigen Verbinden der freien Anschlüssen der schaltbaren Kapazitäten miteinander und weitere Schalter zum niederohmigen Verbinden der freien Anschlüsse der schaltbaren Kapazitäten mit einem Versorgungsspannungsanschluß.

Im folgenden sind die Begriffe Schalter und Schaltmittel gleichbedeutend.

Das erste Schaltmittel kann die beiden schaltbaren Kapazitäten im eingeschalteten Zustand direkt verbinden. Folglich ist im eingeschalteten Zustand des ersten Schaltmittels, d.h. während die schaltbaren Kapazitäten wirksam zum Resonator geschaltet sind, lediglich der Serienwiderstand dieses ersten Transistors wirksam. Zum Wirksamschalten der schaltbaren Kapazitäten ist dabei eine potentialmäßige Anbindung des ersten Schalters an den Versorgungsspannungsanschluß erforderlich. Dies wird mit den weiteren Schaltmitteln erzielt, welche mit ihren gesteuerten Strecken die beiden Anschlüsse der gesteuerten Strecke des ersten Schaltmittels im eingeschalteten Zustand niederohmig mit dem Versorgungsspannungsanschluß verbinden.

Die schaltbaren Kapazitäten können als Kapazitäten mit festem Kapazitätswert ausgeführt sein.

Die beschriebene Ausführung des Wirksamschaltens der schaltbaren Kapazitäten bei einem symmetrisch aufgebauten Oszillator hat gegenüber einer Ausführung mit zwei Transistoren, von denen jeweils einer je eine schaltbare Kapazität mit dem Versorgungsspannungsanschluß verbinden kann, den Vorteil, daß zum einen ein kleinerer Serienwiderstand der Schalteinheit zwischen den schaltbaren Kapazitäten wirksam ist, nämlich derjenige des ersten Schaltmittels, und zugleich bei Wegschalten der schaltbaren Kapazitäten eine kleinere parasitäre Kapazität der Schalteinheit wirksam ist, so daß insgesamt das Kapazitätsverhältnis zwischen beiden Schaltzuständen größer und damit auch das Verhältnis der Schwingfrequenzen der Oszillatorschaltung zwischen zwei Schaltezuständen frequenzmäßig größer ist. Da die beiden weiteren Schaltmittel lediglich eine potentialmäßige Anbindung an die Versorgungsspannung bewirken und daher sehr klein ausgeführt sein können, ist die vorgeschlagene Oszillatorschaltung insgesamt mit sehr geringem Chipflächenbedarf realisierbar. Dabei ist die beschriebene Oszillatorschaltung sehr gut zum Aufbau in integrierter Schaltungstechnik geeignet und mit geringem Aufwand beim Schaltungs-Layout realisierbar.

Insgesamt weist die beschriebene Schaltung ein besonders günstiges Verhältnis des frequenzbestimmenden Schaltwiderstandes der Schalteinheit zu den parasitären Kapazitäten der Schaltmittel der Schalteinheit auf, da der Einschaltwiderstand der weiteren Schaltmittel viel kleiner sein darf als der Einschaltwiderstand zwischen den beiden schaltbaren Kapazitäten.

Wenn die Schaltmittel der Schalteinheit als MOS-Transistoren aufgebaut sind, ergibt sich eine besonders vorteilhafte Integrierbarkeit der Oszillatorschaltung, da die Schaltmittel der Schalteinheit mit einem besonders einfachen und flächensparenden Schaltungs-Layout aufgebaut sein können.

In einer besonders bevorzugten Ausführung der Erfindung haben die Schaltmittel jeweils einen Steuereingang und die Steuereingänge der Schaltmittel sind unter Bildung eines Schaltanschlusses zum Umschalten der Resonanzkreisfrequenz miteinander verbunden. Beispielsweise in MOS-Schaltungstechnik können die Schaltmittel als Transistoren mit gemeinsamem Gate integriert sein.

In einer weiteren, vorteilhaften Ausführungsform der vorliegenden Erfindung ist je ein Anschluß je einer gesteuerten Strecke der weiteren Schaltmittel mit je einem Anschluß der gesteuerten Strecke des ersten Schaltmittels unmittelbar verbunden. Bei Ausführung der Schaltmittel beispielsweise in CMOS-Schaltungstechnik kann so die Integrierbarkeit der Schalteinheit weiter verbessert sein, da sich die unmittelbar aneinander angeschlossenen Transistoren Source-/Drain-Gebiete jeweils teilen können.

In einer weiteren, vorteilhaften Ausführungsform der vorliegenden Erfindung ist der Versorgungsspannungsanschluß ein Bezugspotentialanschluß. Der Bezugspotentialanschluß kann beispielsweise ein Masse-Anschluß des Substrats sein, auf dem die vorliegende Oszillatorschaltung integriert sein kann. Dieser Masse-Anschluß wird auch als Bulk-Anschluß bezeichnet.

In einer weiteren, bevorzugten Ausführungsform der Erfindung sind die Schaltmittel als MOS-Transistoren ausgebildet und in einer gemeinsamen Transistorstruktur integriert, wobei ein Source-Gebiet eines der weiteren Schaltmittel zugleich Drain-Gebiet des ersten Schaltmittel und ein Drain-Gebiet eines anderen der weiteren Schaltmittel zugleich Source-Gebiet des ersten Schaltmittels ist.

In einer weiteren, bevorzugten Ausführungsform der Erfindung sind die Drain-Anschlüsse der Schaltmittel an eine Vorspannungserzeugungsschaltung angeschlossen. Beispielsweise kann der Schaltknoten über je einen hochohmigen Widerstand bei Verwendung von pMOS-Transistoren an einen positiven Anschluß einer Referenzspannungsquelle angeschlossen sein, oder bei Verwendung von nMOS-Transistoren an einen negativen Versorgungsspannungsanschluß. Hierdurch werden die zwischen Drain und Substratanschluß oder Bezugspotentialanschluß gebildeten parasitären Kapazitäten verringert, da diese spannungsabhängig und sperrschichtisoliert sind. Zudem können mit der beschriebenen Maßnahme auch Substratkapazitäten integrierter Abgleichkapazitäten verringert werden, welche eine Sperrschichtisolation gegen den Substratanschluß haben.

In einer weiteren, vorteilhaften Ausführungsform der vorliegenden Erfindung umfaßt das erste Schaltmittel in der Transistorstruktur mehrere, parallel geschaltete integrierte Transistorelemente. Das Parallelschalten einzelner Transistorelemente, welche auch als Transistorfinger bezeichnet werden und einen gemeinsamen Gateanschluß haben können, führt zu einem besseren Rauschverhalten der gesamten Oszillatorschaltung.

In einer weiteren, bevorzugten Ausführungsform der Erfindung ist der Oszillatorkern als abstimmbarer Resonanzkreis ausgeführt. Hierfür können beispielsweise Kapazitätsdioden vorgesehen sein, welche an die Kapazitäten des Oszillatorkerns angeschlossen sein können.

In einer weiteren, vorteilhaften Ausführungsform der Erfindung weist die Oszillatorschaltung einen als Differenzverstärker ausgebildeten Entdämpfungsverstärker auf, der mit dem Oszillatorkern gekoppelt ist. Der Differenzverstärker stellt dabei eine negative Impedanz bereit, die, um eine Einschaltbedingung zu erfüllen, die Dämpfung des Oszillatorkerns leicht überkompensiert und in einem Normalbetriebszustand die Dämpfung der Oszillatorschaltung gerade kompensiert.

In einer weiteren, vorteilhaften Ausführungsform der Erfindung weist der Entdämpfungsverstärker zwei kreuzgekoppelte CMOS-Transistoren auf, welche an den Schwingungsknoten angeschlossen sind. Die CMOS-Transistoren können dabei galvanisch zur Bildung einer Gegenkopplung kreuzgekoppelt sein oder es können nichtgalvanische Kopplungen vorgesehen sein, beispielsweise transformatorische, induktive oder kapazitive Kopplungen.

In einer weiteren, vorteilhaften Ausführungsform der Erfindung ist der Versorgungsspannungsanschluß zur Bereitstellung eines Bulkpotentials an den weiteren Schaltmitteln an eine Gleichspannungsquelle oder an eine Gleichstromquelle angeschlossen.

Dieses Anlegen einer Spannung oder eines Gleichstromes an den Substrat- oder Bulkanschluß verringert den Durchschaltwiderstand der Schaltmittel. Der dabei wirksame physikalische Effekt wird allgemein als Bulkeffekt bezeichnet. Hierfür kann beispielsweise der Substratanschluß der Schalttransistoren oder Schaltmittel über einen hochohmigen Widerstand an das schaltende Potential, das Gatepotential angeschlossen sein. Bei Einschalten der Transistoren oder Schaltmittel fließt dann über diesen Widerstand ein Strom, der die zwischen Drain und Substrat oder Bulkanschluß gebildete Diode in Flußrichtung polt. Hierbei entsteht eine Spannung, die den On-Widerstand oder Durchschaltwiderstand der Schaltmittel verringert.

In einer weiteren, vorteilhaften Ausführungsform der Erfindung ist ein Mittel zur Erhöhung des Signalpegels vorgesehen, welches an eine die Oszillatorschaltung versorgende Spannungsquelle angeschlossen ist und an seinem Ausgang mit Steuereingängen der Schaltmittel verbunden ist. Das den Steuereingängen der Schaltmittel zuführbare Steuersignal kann beispielsweise über einen Spannungsverdoppler in ein Signal mit höherem Pegel konvertiert sein, wobei der höhere Pegel höher als eine Versorgungsspannung der Schaltung sein kann. Dies kann beispielsweise mit einer Spannungsverdopplungsschaltung und einem Pegelshifter erreicht sein, welcher an die Steuereingänge der Schaltmittel angeschlossen sein kann. Eine größere Gatespannung am Steuereingang der als CMOS-Transistoren ausgeführten Schaltmittel führt dabei zu einer weiteren Verringerung des Durchschaltwiderstandes der Schaltmittel.

Weitere Einzelheiten der Erfindung sind in den Unteransprüchen angegeben.

Die Erfindung wird nachfolgend an mehreren Ausführungsbeispielen anhand der Zeichnungen näher erläutert. Es zeigen:
- Figur 1: ein vereinfachtes Schaltbild einer beispielhaften ersten Ausführungsform der vorliegenden Erfindung mit einer Schalteinheit,
- Figur 2: ein beispielhaftes Layout der Schaltmittel der Schalteinheit von Figur 1 in CMOS-Technologie,
- Figur 3: eine Weiterbildung der Schalteinheit von Figur 1 mit verringerter parasitärer Transistorkapazität,
- Figur 4: eine Weiterbildung der Schalteinheit von Figur 1 unter Ausnutzung des Bulkeffektes,
- Figur 5: eine weitere Möglichkeit der Realisierung der Schalteinheit von Figur 1 unter Ausnutzung des Bulkeffektes in vereinfachter Form und
- Figur 6: ein Schaltbild einer Weiterbildung der Schalteinheit von Figur 1 mit erhöhtem Steuerpegel der Schaltmittel.

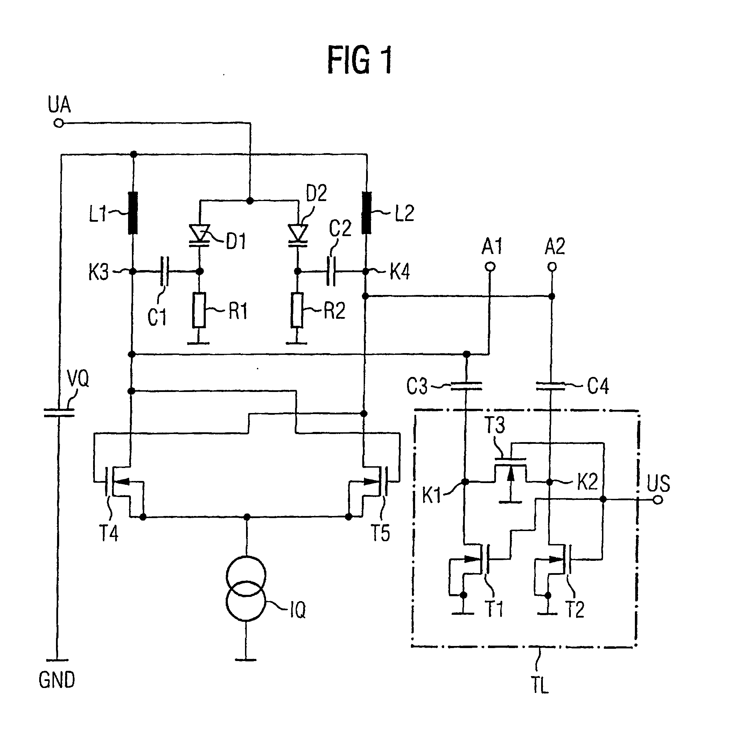

Figur 1 zeigt einen Oszillatorkern in symmetrischer Ausführung mit zwei Kapazitäten C1, C2, an die an einem ersten Anschluß je ein Kathodenanschluß einer als Kapazitätsdiode ausgeführten Varaktordiode D1, D2 angeschlossen ist. An den miteinander verbundenen Anodenanschlüssen der Varaktordioden D1, D2, welche als Abstimmdioden der Resonanzschaltung dienen, ist ein Abstimm-Anschluß UA angeschlossen, dem eine Steuerspannung des spannungsgesteuerten Oszillators zuführbar ist. Die freien Anschlüsse der Kapazitäten C1, C2 sind in einem symmetrischen Schwingknoten K3, K4 an je eine Resonator-Induktivität L1, L2 angeschlossen. Die freien Anschlüsse der Induktivitäten L1, L2 sind miteinander verbunden und an den positiven Spannungsanschluß einer Spannungsquelle VQ, welche die Oszillatorschaltung versorgt, angeschlossen.

Ein als Differenzverstärker ausgeführter Entdämpfungsverstärker umfaßt zwei kreuzgekoppelte MOS-Transistoren T4, T5, welche mit ihren Drain-Anschlüssen an den Schwingknoten K3, K4 und mit ihren Source-Anschlüssen miteinander und mit einer Stromquelle IQ verbunden sind.

Zuschaltbare Kapazität C3, C4 sind an den Schwingungsknoten K3, K4 mit je einem ihrer Anschlüsse angeschlossen, und bilden mit ihren freien Anschlüssen einen Schaltknoten K1, K2. An diesen Schaltknoten K1, K2 ist eine Schalteinheit TL angeschlossen, welche die zuschaltbaren Kapazitäten C3, C4 bei Bedarf wirksam zum Resonator hinzu schalten kann.

Im einzelnen umfaßt die Schalteinheit TL ein erstes Schaltmittel T3, welches als MOS-Transistor ausgeführt ist, dessen Substratanschluß mit einem Bezugspotentialanschluß GND verbunden und dessen Drain- und Source-Anschluß an den symmetrischen Schaltknoten K1, K2 angeschlossen sind. Weiterhin sind an den Schaltknoten K1, K2 weitere Schaltmittel T1, T2, welche ebenfalls als MOS-Transistoren ausgeführt sind, jeweils mit ihrem Drain-Anschluß angeschlossen. Die Source-Anschlüsse von erstem und zweitem Transistor T1, T2 sind unmittelbar mit Bezugspotentialanschluß GND verbunden. Die Steuereingänge, respektive Gate-Anschlüsse der Transistoren T1, T2, T3 sind miteinander in einem Schalt-Anschluß US verbunden, dem eine Schaltspannung zum Zu- oder Wegschalten der zuschaltbaren Kapazitäten C3, C4 zuführbar ist.

Gegenüber üblichen Schaltanordnungen der Schalteinheit TL, bei denen der Transistor T3 nicht vorhanden ist, hat vorliegende Schaltung den Vorteil, daß der Stromfluß von Kapazität C3 zu Kapazität C4 und umgekehrt nicht über gesteuerte Strekken zweier Transistoren und über Bezugspotential, sondern lediglich über die gesteuerte Strecke eines Transistors, hier des Transistors T3 fließt. Demnach ist lediglich ein Transistor T3 bezüglich Schaltwiderstand im eingeschalteten Zustand wirksam, so daß der On-Widerstand zwischen den schaltbaren Kapazitäten signifikant verringert ist. Auch im ausgeschalteten Zustand sind die parasitär kapazitiven Eigenschaften der Schalteinheit verbessert, da die weiteren Schaltmittel, die Transistoren T1, T2, eine kleine parasitäre Kapazität gegen Bezugspotentialanschluß GND haben. Denn da der Strom zwischen Kapazitäten C3 und C4 über Transistor T3 fließen kann, dürfen die Transistoren T1, T2 sehr klein ausgeführt sein, wodurch sie geringe parasitäre Kapazitäten haben.

Die beschriebene Oszillatorschaltung hat demnach ein besonders großes Verhältnis von wirksamer Resonanzkreiskapazität mit zugeschalteten schaltbaren Kapazitäten gegenüber der Resonanzkreiskapazität ohne zugeschaltete schaltbare Kapazitäten, auch unter Berücksichtigung der jeweils wirksamen parasitären Kapazitäten. Hierdurch ist das Verhältnis der Schwingfrequenzen, zwischen denen umschaltbar ist, sehr groß. Da zudem der Serienwiderstand der Schalteinheit TL sehr klein ist, weist die Oszillatorschaltung insgesamt ausgezeichnete Rauscheigenschaften auf.

Selbstverständlich können anstelle der gezeigten schaltbaren Kapazitäten C3, C4 weitere, beispielsweise binär abgestufte, mit Schalteinheit TL schaltbare Kapazitäten vorgesehen sein, so daß zwischen mehr als zwei Oszillatorfrequenzen umgeschaltet werden kann.

Die Ausgangsfrequenz der Schaltung kann am symmetrischen Ausgang A1, A2, welcher mit dem Schaltknoten K3, K4 verbunden ist, abgeleitet werden.

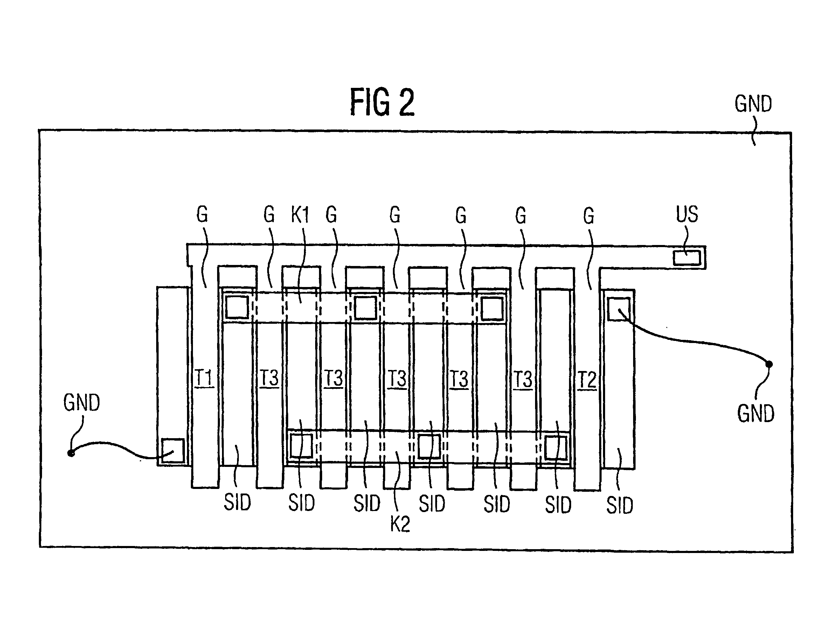

Figur 2 zeigt ein mögliches Layout der Schalteinheit TL in MOS-Technologie in einer vereinfachten Draufsicht. Dabei ist in einem äußeren, rechteckförmigen Rahmen der als Bulk oder Substrat ausgeführte Bezugspotentialanschluß GND gezeigt. Dieser ist mit je einem Source/Drain-Anschluß S/D von Transistor T1 und Transistor T2, jeweils außen angeordnet, verbunden. Je ein weitere Source/Drain-Anschluß von Transistor T1 und T2 bildet je einen Source/Drain-Anschluß je eines Transistorelementes des ersten Schaltmittels T3. Insgesamt umfaßt der Transistor T3 fünf Einzeltransistoren, welche differentiell beschaltet sind. Hierfür sind die Kontaktelemente der Schaltknoten K1, K2 vorgesehen, welche jeweils kammartig ineinander greifende Source/Drain-Gebiete S/D abwechselnd miteinander verbinden. Die Source-/Drain-Gebiete S/D sind demnach abwechselnd mit Schaltknoten K1 und Schaltknoten K2 verbunden. Zwischen den Source-/Drain-Gebieten S/D ist jeweils ein Kanal der MOS-Einzeltransistoren angeordnet. Über diesem Kanal ist je ein Gate-Anschluß vorgesehen, wobei alle Gate-Anschlüsse G von erstem, zweitem und allen dritten Transistoren T1, T2, T3 miteinander galvanisch verbunden sind. Der die Gate-Gebiete G verbindende Gate-Anschluß oder Schaltanschluß US kann einseitig, wie gezeigt, oder beidseitig ausgeführt sein.

Insgesamt ist das Layout der Schalteinheit besonders platzsparend und mit geringem Aufwand realisierbar. Da die Transistoren T1 bis T3 eine gemeinsame Transistorstruktur nutzen können, insbesondere da sie einen gemeinsamen Gate-Anschluß G haben, ist der Flächenbedarf und der Layout-Aufwand besonders klein. Man erkennt, daß Transistor T3, welcher im gezeigten Ausführungsbeispiel fünf Einzeltransistorelemente umfaßt, durch Parallelschalten mehrerer Einzeltransistoren eine verhältnismäßig große Kanalweite aufweist, während die Transistoren T1 und T2 in besonders kleinen Strukturen realisiert sind. Dies führt dazu, daß im ausgeschalteten Zustand die Transistoren T1 und T2 besonders geringe parasitäre Kapazitäten gegen Bezugspotential GND haben und bei eingeschalteten Transistoren der Durchlasswiderstand oder Serienwiderstand des dritten Transistors T3 besonders gering ist. Somit ist sichergestellt, daß die sonst widersprüchlichen Forderungen nach geringem Einschaltwiderstand und damit geringem Phasenrauschen des Oszillators bei dennoch kleinen parasitären Kapazitäten gegen Bezugspotential GND vereinbar sind.

In alternativen Ausführungsformen könnte der Transistor T3 beliebig viele Einzeltransistoren umfassen. Durch die Parallelschaltung der beliebig vielen Einzeltransistoren kann eine beliebig große Kanalweite erzielt sein.

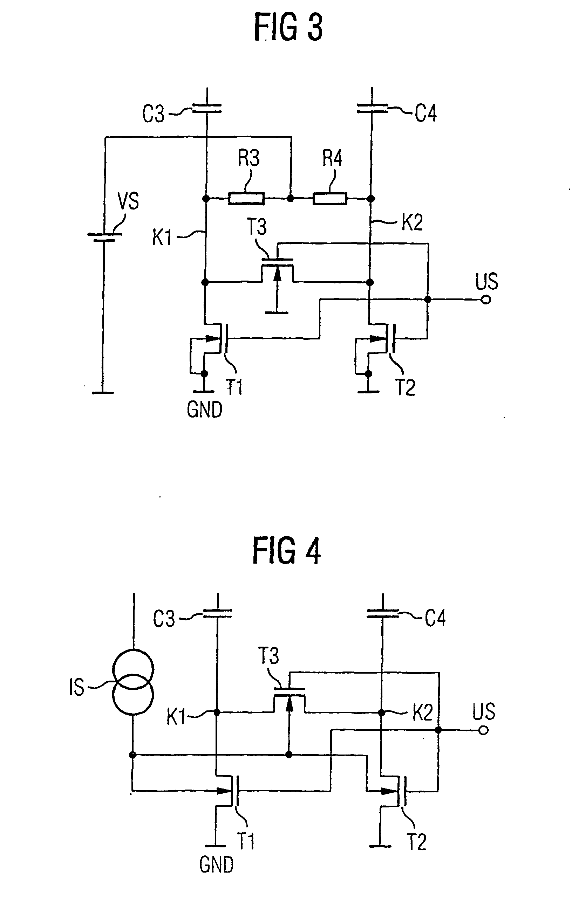

Figur 3 zeigt eine Schalteinheit, welche gegenüber der Schalteinheit TL von Figur 1 eine weiter verringerte parasitäre Kapazität bei ausgeschalteten Transistoren hat. Dabei ist je ein hochohmiger Widerstand R3, R4 zwischen den symmetrischen Schaltknoten K1, K2 und den positiven Anschluß einer Versorgungsspannungsquelle VS geschaltet. Hierdurch ist bewirkt, daß aufgrund der anliegenden Gleichspannung die parasitäre, zwischen Drain-Anschlüssen und Masse- oder Bezugspotentialanschluß GND gebildete Kapazität der Transistoren T1, T2 deutlich verringert ist. Anstelle der Widerstände R3, R4 könnten auch kleine MOS-Transistoren vorgesehen sein. Sind die Transistoren T1, T2 nicht im pMOS-Technik wie gezeigt, sondern im nMOS-Technik ausgeführt so ist die Spannungsquelle VS umzupolen.

Wenn bei der Oszillatorschaltung gemäß Figur 1 mit einer Schalteinheit gemäß Figur 3 zusätzliche Abgleichkapazitäten integriert sind, so werden mit der beschriebenen Maßnahme gemäß Figur 3 auch die Substratkapazitäten der integrierten Abgleichkapazitäten mit Sperrschichtisolation gegen Substrat verringert, wodurch die parasitären Kapazitäten der Gesamtanordnung weiter reduziert sind.

Figur 4 zeigt eine Weiterbildung der Schalteinheit TL von Figur 1 dahingehend, daß der Durchschaltwiderstand der Schalttransistoren weiter verringert ist. Hierfür ist eine Stromquelle IS vorgesehen, welche eine Ausnutzung des sogenannten Bulkeffektes ermöglicht. Denn durch die Vorspannung (Biasing) des Bulkpotentials oder Substratpotentials oder Bezugspotentials werden die Einschaltwiderständen der Transistoren T1, T2, T3 verringert.

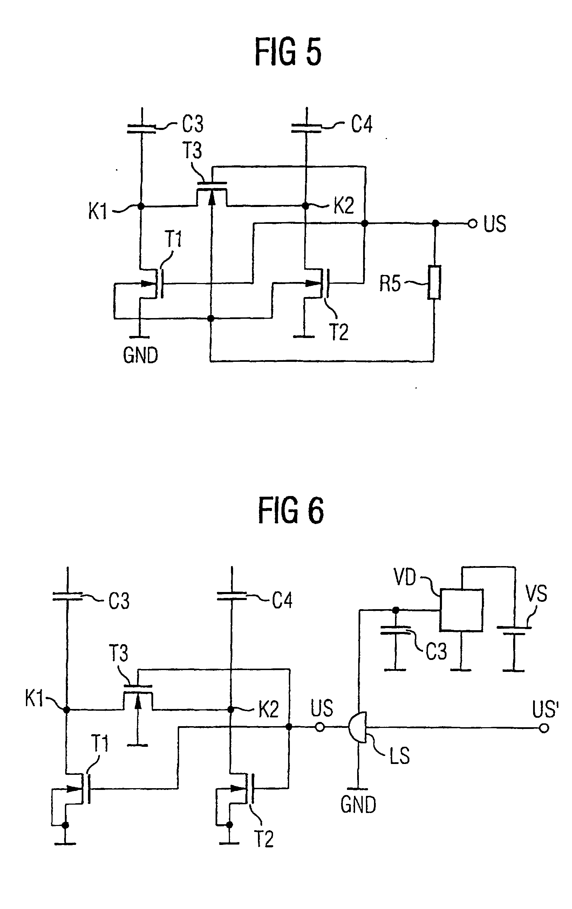

Figur 5 zeigt eine vereinfachte Ausführung der Schaltung zum Ausnutzen des Bulkeffektes gemäß Figur 4. Anstelle der Stromquelle IS ist dabei jedoch ein hochohmiger Widerstand R5 vorgesehen, der einerseits an die Substratanschlüsse der Transistoren T1, T2, T3 und andererseits an den Steueranschluß der gemeinsamen Gate-Anschlüsse der Transistoren T1 bis T3 angeschlossen ist. Mit dem Einschalten der Transistoren T1 bis T3 fließt über den Widerstand R5 ein Strom, der eine zwischen Drain- und Substratanschlüssen der Transistoren gebildete Diode in Flußrichtung polt. Der Bulkeffekt bewirkt, daß die dabei entstehende Spannung zu einer Verkleinerung des Durchschaltwiderstandes der Transistoren führt.

Figur 6 zeigt eine Weiterbildung der Schalteinheit TL aus Figur 1 dahingehend, daß eine Spannungsverdopplungsschaltung VD mit den Gate-Anschlüssen der Transistoren T1 bis T3 gekoppelt ist. Durch die Vergrößerung des Gatepotentials der Transistoren T1 bis T3 über ein Versorgungsspannungspotential hinaus wird der Durchschaltwiderstand der Transistoren T1 bis T3 weiter verringert. Im einzelnen ist eine Spannungsverdopplungsschaltung VD vorgesehen, die eingangsseitig mit einer Spannungsquelle VS verbunden ist. Ausgangsseitig an der Spannungsverdopplungsschaltung VD ist eine Glättungskapazität C3 gegen Bezugspotentialanschluß GND vorgesehen. Weiterhin ist an den Ausgang der Spannungsverdopplungsschaltung VD ein Levelshifter LS angeschlossen, welcher das Potential an einem Schaltanschluß US', welcher eingangsseitig angeschlossen ist, an einem ausgangssseitigen Schalt-Anschluß US erhöht. Dieser Schalt-Anschluß US ist mit den Steuereingängen der Transistoren T1 bis T3 verbunden.

Die beschriebenen Ausführungsbeispiele einer Oszillatorschaltung sind besonders zur Anwendung in spannungsgesteuerten Oszillatoren geeignet, wie sie beispielsweise im Mobilfunk eingesetzt sind.

### Bezugszeichenliste

- A1: Ausgang
- A2: Ausgang
- C1: Kondensator
- C2: Kondensator
- C3: zuschaltbare Kapazität
- C4: zuschaltbare Kapazität
- D1: Abstimmdiode
- D2: Abstimmdiode
- G: Gate
- GND: Bezugspotentialanschluß
- IS: Stromquelle
- K1: Schaltknoten
- K2: Schaltknoten
- K3: Schwingknoten
- K4: Schwingknoten
- L1: Induktivität
- L2: Induktivität
- LS: Pegelshifter
- R1: Widerstand
- R2: Widerstand
- R3: Widerstand
- R4: Widerstand
- R5: Widerstand
- S/D: Source-/Drain-Gebiet
- T1: Transistor
- T2: Transistor
- T3: Transistor
- T4: Transistor
- T5: Transistor
- TL: Schalteinheit
- UA: Abstimm-Anschluß
- US: Schalt-Anschluß
- US': Schalt-Anschluß
- VD: Spannungsverdoppler
- VQ: Versorgungsspannungsquelle
- VS: Spannungsquelle

## Patentansprüche

1. Oszillatorschaltung, aufweisend
- einen symmetrisch aufgebauten Oszillatorkern mit zumindest je einer Induktivität (L1) und zumindest je einer Kapazität (C1), die einen Resonanzkreis mit einem symmetrischen Schwingknoten (K3, K4) bilden,
- zwei schaltbare Kapazitäten (C3, C4), die mit je einem Anschluß mit dem Schwingknoten (K3, K4) verbunden sind und an ihren freien Anschlüssen einen Schaltknoten (K1, K2) bilden und
- eine Schalteinheit (TL) zum Verändern einer Resonanzkreis-Frequenz durch Wirksamschalten der schaltbaren Kapazitäten (C3, C4), umfassend einen ersten Schalter (T3) zum direkten niederohmigen Verbinden der freien Anschlüssen der schaltbaren Kapazitäten (C3, C4) miteinander und weitere Schalter (T1, T2) zum niederohmigen Verbinden der freien Anschlüsse der schaltbaren Kapazitäten (C3, C4) mit einem Versorgungsspannungsanschluß (GND).

2. Oszillatorschaltung nach Anspruch 1,
**dadurch gekennzeichnet, daß**
erster und weitere Schalter (T1, T2, T3) jeweils einen Steuereingang haben und die Steuereingänge unter Bildung eines Schalt-Anschlusses (US) zum Umschalten der Resonanzkreis-Frequenz miteinander verbunden sind.

3. Oszillatorschaltung nach Anspruch 1 oder 2,
**dadurch gekennzeichnet, daß**
je ein Anschluß je einer gesteuerten Strecke der weiteren Schalter (T1, T2) mit je einem Anschluß der gesteuerten Strecke des ersten Schalters (T3) unmittelbar verbunden ist.

4. Oszillatorschaltung nach einem der Ansprüche 1 bis 3,
**dadurch gekennzeichnet, daß**
der Versorgungsspannungsanschluß (GND) ein Bezugspotentialanschluß ist.

5. Oszillatorschaltung nach einem der Ansprüche 1 bis 4,
**dadurch gekennzeichnet, daß**
die Schalter (T1, T2, T3) als MOS-Transistoren ausgebildet und in einer gemeinsamen Transistorstruktur der Schalteinheit (TL) integriert sind, wobei ein Source-Gebiet eines der weiteren Schalter (T1) zugleich Drain-Gebeit des ersten Schalters (T3) und ein Drain-Gebiet eines anderen weiteren Schalters (T2) zugleich Source-Gebiet des ersten Schalters (T3) ist.

6. Oszillatorschaltung nach Anspruch 5,
**dadurch gekennzeichnet, daß**
die Drain-Anschlüsse der weiteren Schalter (T1, T2) an eine Vorspannungserzeugungsschaltung (VS, R3, R4) angeschlossen sind.

7. Oszillatorschaltung nach Anspruch 5 oder 6,
**dadurch gekennzeichnet, daß**
der erste Schalter (T3) in der Transistorstruktur mehrere, parallel geschaltete integrierte Transistorelemente (T3) umfaßt.

8. Oszillatorschaltung nach einem der Ansprüche 1 bis 7,
**dadurch gekennzeichnet, daß**
der Oszillatorkern als abstimmbarer Resonanzkreis ausgeführt ist.

9. Oszillatorschaltung nach einem der Ansprüche 1 bis 8,
**dadurch gekennzeichnet, daß**
die Oszillatorschaltung einen als Differenzverstärker ausgebildeten Entdämpfungsverstärker (T4, T5, IQ) aufweist, der mit dem Oszillatorkern gekoppelt ist.

10. Oszillatorschaltung nach Anspruch 9,
**dadurch gekennzeichnet, daß**
der Entdämpfungsverstärker zwei kreuzgekoppelte MOS-Transistoren (T5, T4) umfaßt, welche an den Schwingknoten (K3, K4) angeschlossen sind.

11. Oszillatorschaltung nach einem der Ansprüche 1 bis 10, **dadurch gekennzeichnet, daß**
der Versorgungsspannungsanschluß (GND) zur Bereitstellung eines Bulkpotentials an den weiteren Schaltern (T1, T2) an eine Gleichspannungsquelle (VS) oder eine Gleichstromquelle (IS) angeschlossen ist.

12. Oszillatorschaltung nach einem der Ansprüche 1 bis 11,
**dadurch gekennzeichnet, daß**
ein Mittell (VD,LS) zur Erhöhung eines Signalpegels am Schalt-Anschluß (US) vorgesehen ist, welches an eine Spannungsquelle (VS) angeschlossen ist und an seinem Ausgang mit Steuereingängen der Schalter (T1, T2, T3) verbunden ist.

## Claims

1. Oscillator circuit, having
- a symmetrically constructed oscillator core with a least one respective inductance (L1) and at least one respective capacitance (C1), which form a resonant circuit with a symmetrical oscillation node (K3, K4),
- two switchable capacitances (C3, C4), which are connected by a respective terminal to the oscillation node (K3, K4) and form a switching node (K1, K2) at their free terminals and
- a switching unit (TL) for altering a resonant circuit frequency by activating the switchable capacitances (C3, C4), comprising a first switch (T3) for the direct low-impedance connection of the free terminals of the switchable capacitances (C3, C4) to one another, and further switches (T1, T2) for the low-impedance connection of the free terminals of the switchable capacitances (C3, C4) to a supply voltage terminal (GND).

2. Oscillator circuit according to Claim 1,
**characterized in that**
first and further switches (T1, T2, T3) in each case have a control input and the control inputs are connected to one another to form a switching terminal (US) for changing over the resonant circuit frequency.

3. Oscillator circuit according to Claim 1 or 2,
**characterized in that**
a respective terminal of a respective controlled path of the further switches (T1, T2) is directly connected to a respective terminal of the controlled path of the first switch (T3).

4. Oscillator circuit according to one of Claims 1 to 3,
**characterized in that**
the supply voltage terminal (GND) is a reference-ground potential terminal.

5. Oscillator circuit according to one of Claims 1 to 4,
**characterized in that**
the switches (T1, T2, T3) are designed as MOS transistors and are integrated in a common transistor structure of the switching unit (TL), a source region of one of the further switches (T1) at the same time being a drain region of the first switch (T3) and a drain region of another further switch (T2) at the same time being a source region of the first switch (T3).

6. Oscillator circuit according to Claim 5,
**characterized in that**
the drain terminals of the further switches (T1, T2) are connected to a bias voltage generating circuit (VS, R3, R4).

7. Oscillator circuit according to Claim 5 or 6,
**characterized in that**
the first switch (T3) in the transistor structure comprises a plurality of integrated transistor elements (T3) connected in parallel.

8. Oscillator circuit according to one of Claims 1 to 7,
**characterized in that**
the oscillator core is embodied as a tuneable resonant circuit.

9. Oscillator circuit according to one of Claims 1 to 8,
**characterized in that**
the oscillator circuit has a deattenuation amplifier (T4, T5, IQ), which is designed as a differential amplifier and is coupled to the oscillator core.

10. Oscillator circuit according to Claim 9,
**characterized in that**
the deattenutation amplifier comprises two crosscoupled MOS transistors (T5, T4) connected to the oscillation node (K3, K4).

11. Oscillator circuit according to one of Claims 1 to 10,
**characterized in that**
the supply voltage terminal (GND), for providing a bulk potential at the further switches (T1, T2), is connected to a DC voltage source (VS) or a DC current source (IS).

12. Oscillator circuit according to one of Claims 1 to
11,
**characterized in that**
a means (VD, LS) for increasing a signal level at the switching terminal (US) is provided, which is connected to a voltage source (VS) and, at its output, is connected to control inputs of the switches (T1, T2, T3).

## Revendications

1. Circuit d'oscillateur comprenant
- un noyau d'oscillateur de constitution symétrique, ayant au moins respectivement une inductance (L1) et au moins respectivement une capacité (C1) qui forment un circuit résonnant ayant un noeud (K3, K4) d'oscillation symétrique,
- deux capacités (C3, C4) commutables qui sont reliées par respectivement une borne au noeud (K3, K4) d'oscillation et qui forment sur leurs bornes libres un noeud (K1, K2) de commutation, et
- une unité (TL) de commutation, pour modifier une fréquence du circuit de résonance en rendant actives les capacités (C3, C4) commutables, comprenant un premier commutateur (T3) de liaison directe entre elles, à petite valeur ohmique, des bornes libres des capacités (C3, C4) commutables et d'autres commutateurs (T1, T2) de liaison, à petite valeur ohmique, des bornes libres des capacités (C3, C4) commutables à une borne (GND) de tension d'alimentation.

2. Circuit d'oscillateur suivant la revendication 1,
**caractérisé en ce que**
le premier et les autres commutateurs (T1, T2, T3) ont respectivement une entrée de commande et les entrées de commande sont reliées entre elles avec formation d'une borne (US) de commutation, pour commuter la fréquence du circuit résonnant.

3. Circuit d'oscillateur suivant la revendication 1 ou 2,
**caractérisé en ce que**
respectivement une borne d'une section commandée des autres commutateurs (T1, T2) est reliée directement à respectivement une borne de la section commandée du premier commutateur (T3).

4. Circuit d'oscillateur suivant l'une des revendications 1 à 3,
**caractérisé en ce que**
la borne (GND) de tension d'alimentation est une borne de potentiel de référence.

5. Circuit d'oscillateur suivant l'une des revendication 1 à 4,
**caractérisé en ce que**
les commutateurs (T1, T2, T3) sont constitués sous la forme de transistors MOS et sont intégrés dans une structure commune de transistor de l'unité (TL) de commutation, une zone de source de l'un des autres commutateurs (T1) étant en même temps une zone de drain du premier commutateur (T3) et une zone de drain d'un autre commutateur (T2) supplémentaire étant en même temps une zone de source du premier commutateur (T3).

6. Circuit d'oscillateur suivant la revendication 5,
**caractérisé en ce que**
les bornes de drain des autres commutateurs (T1, T2) sont reliées à un circuit (VS, R3, R4) de production d'une tension de polarisation.

7. Circuit d'oscillateur suivant la revendication 5 ou 6,
**caractérisé en ce que**
le premier commutateur (T3) de la structure de transistor comprend plusieurs éléments (T3) de transistor intégrés et montés en parallèle.

8. Circuit d'oscillateur suivant l'une des revendications 1 à 7,
**caractérisé en ce que**
le noyau de l'oscillateur est réalisé en circuit résonnant accordable.

9. Circuit d'oscillateur suivant l'une des revendications 1 à 8,
**caractérisé en ce que**
le circuit d'oscillateur comporte un amplificateur (T4, T5, IQ) de régénération, constitué sous la forme d'un amplificateur différentiel et couplé au noyau de l'oscillateur.

10. Circuit d'oscillateur suivant la revendication 9,
**caractérisé en ce que**
l'amplificateur de régénération comprend deux transistors (T5, T4) MOS rétrocouplés et reliés au noeud (K3, K4) d'oscillation.

11. Circuit d'oscillateur suivant l'une des revendications 1 à 10,
**caractérisé en ce que**
la borne (GND) de tension d'alimentation est reliée, pour la mise à disposition d'un potentiel de masse aux autres commutateurs (T1, T2), à une source (VS) de tension continu ou à une source (IS) de courant continu.

12. Circuit d'oscillateur suivant l'une des revendications 1 à 11,
**caractérisé en ce que**
il est prévu sur la borne (U S) de commutation un moyen d'élévation du niveau (VD, LS) du signal, qui est relié à une source (VS) de tension et par sa sortie à des entrées de commande des commutateurs (T1, T2, T3).
